Europäisches Patentamt

(19) European Patent Office

Office européen des brevets

(11) Numéro de publication : **0 120 719**
**B1**

(12) **FASCICULE DE BREVET EUROPÉEN**

(45) Date de publication du fascicule du brevet :
30.09.87

(21) Numéro de dépôt : **84400095.0**

(22) Date de dépôt : **17.01.84**

(51) Int. Cl.⁴ : **G 11 C 19/08**

(54) **Mémoire à bulles magnétiques à motifs non implantés et son procédé de commande.**

(30) Priorité : **20.01.83 FR 8300866**

(43) Date de publication de la demande :
**03.10.84 Bulletin 84/40**

(45) Mention de la délivrance du brevet :
**30.09.87 Bulletin 87/40**

(84) Etats contractants désignés :
**DE GB NL**

(56) Documents cités :
**GB-A- 2 094 082**

(73) Titulaire : **COMMISSARIAT A L'ENERGIE ATOMIQUE
Etablissement de Caractère Scientifique Technique
et Industriel
31/33, rue de la Fédération
F-75015 Paris (FR)**

(72) Inventeur : **Jouve, Hubert
8, Domaine des Plantées
F-38330 Biviers (FR)**
Inventeur : **Magnin, Joel
3, rue Doyen Gosse
F-38400 Saint Martin d'Heres (FR)**

(74) Mandataire : **Mongrédien, André et al
c/o BREVATOME 25, rue de Ponthieu
F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a pour objet une mémoire à bulles magnétiques à motifs non implantés et son procédé de commande.

Elle s'applique notamment à la mémorisation d'informations binaires ou bits, matérialisés sous la forme de domaines magnétiques isolés, qualifiés de bulles ; ces domaines généralement cylindriques, présentent une aimantation inverse de celle du reste du matériau magnétique (grenat) constituant la couche dans laquelle ces domaines sont formés.

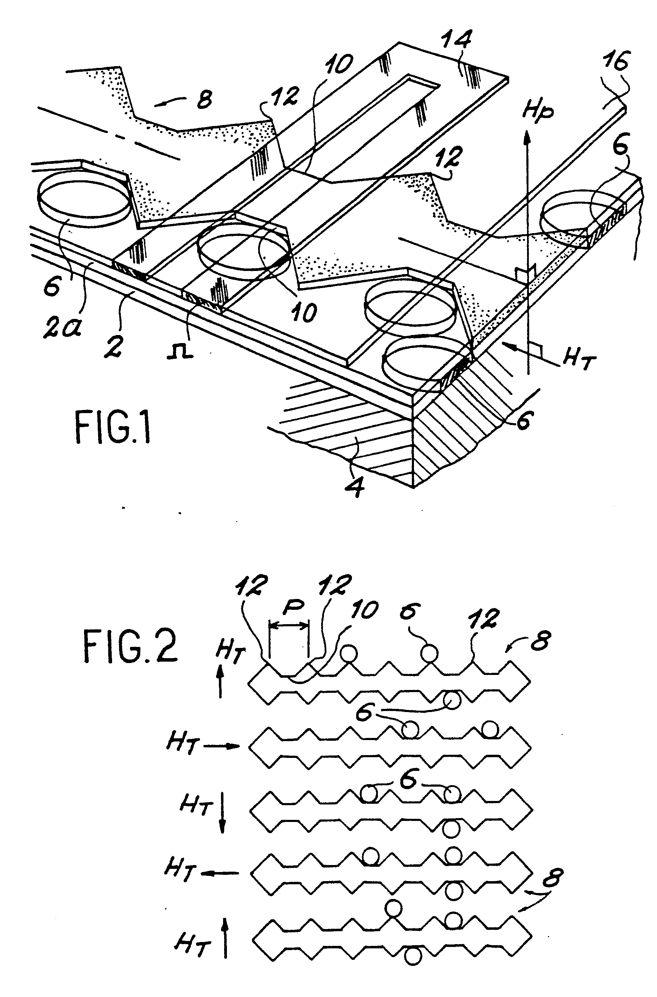

Sur la figure 1, on a représenté une partie d'une mémoire à bulles magnétiques. Cette mémoire comprend une couche magnétique monocristalline 2 telle qu'un film de grenat magnétique supporté par un grenat monocristallin amagnétique 4. Dans cette couche 2, il est possible de créer des domaines de bulles magnétiques telles que 6. Ces bulles magnétiques peuvent être stabilisées par application d'un champ magnétique continu $H_P$ perpendiculaire au plan de la couche magnétique 2. Dans la pratique, ce champ magnétique est créé par un aimant permanent assurant ainsi la non volatilité des informations contenues dans la mémoire.

Dans une memoire à bulles magnétiques, le déplacement des bulles 6 est réalisé en appliquant un champ continu tournant $H_T$, dirigé suivant une direction parallèle à la surface de la couche magnétique 2. Le déplacement des bulles se fait autour de motifs dits de propagation 8, définis dans la partie supérieure 2a de la couche magnétique 2.

Ces motifs 8 présentant la forme de cercles, d'ellipses, de losanges, de triangles, de polygones, etc. peuvent être réalisés en un matériau à base de fer et de nickel, ou bien obtenus en implantant des ions dans la partie supérieure 2a de la couche magnétique, à travers un masque permettant de définir la forme de ces motifs. Dans ce dernier cas, étant donné que l'implantation ionique n'est effectuée qu'autour des motifs, ces motifs sont appelés des motifs non implantés. Les motifs de propagation sont généralement contigus et ils présentent des formes et des dimensions identiques. Du fait de leur forme, par exemple des losanges comme représenté sur la figure 1, deux motifs adjacents délimitent entre eux deux cavités ou creux 10. Ces motifs comportent aussi des sommets ou pointes 12.

Sur la figure 2, on a représenté le déplacement des bulles magnétiques 6 sous l'action du champ magnétique tournant $H_T$. Comme représenté, le déplacement des bulles le long de ces motifs 8 se fait généralement pendant une durée égale au tiers de la période de rotation du champ magnétique $H_T$ plan, les bulles restant immobiles dans les cavités 10 définies entre deux motifs adjacents, pendant le reste du cycle. On a réalisé ainsi des registres à décalage dans lesquels l'information binaire « 1 » est représentée par la présence d'une bulle et l'information binaire « 0 » par l'absence d'une bulle. Le déplacement effectué par les bulles magnétiques pendant une période de rotation du champ est généralement appelé un pas, il représente par exemple la distance P séparant deux sommets 12 de deux motifs contigus 8.

En plus de ces motifs de propagation, il est nécessaire d'utiliser des conducteurs électriques pour réaliser dans la mémoire à bulles, des fonctions d'écriture, de lecture non destructive, de transfert de registre à registre et d'effacement. Comme représenté sur la figure 1, ces conducteurs électriques tels que 14 « traversent » les motifs de propagation 8. Ces conducteurs 14 sont disposés notamment sur une couche diélectrique 16 située au-dessus de la couche de matériau 2.

Un des principaux types de mémoire à bulles magnétiques connu comprend un ensemble de boucles, ou registres, dites mineures servant au stockage des informations, associé à une ou deux boucles, ou registres, dites majeures, constituant les stations d'accès à la mémoire. Les boucles mineures sont disposées longitudinalement, les unes à côté des autres et les boucles majeures sont orientées perpendiculairement aux boucles mineures. Les bulles magnétiques se trouvant dans les boucles mineures peuvent être transférées dans les boucles majeures et réciproquement, par l'intermédiaire de portes de transfert unidirectionnelles ou bidirectionnelles.

Lorsque l'on utilise une seule boucle majeure, la lecture et l'écriture des informations se font au moyen de cette unique boucle. Dans ce premier cas, on parle d'une mémoire présentant une organisation majeure-mineure. En revanche, lorsque l'on utilise deux boucles majeures, l'écriture des informations se fait par l'intermédiaire de l'une de ces deux boucles et la lecture des informations par l'intermédiaire de l'autre boucle. Ces boucles majeures sont généralement situées de part et d'autre des boucles mineures. Dans ce dernier cas (deux boucles), on parle généralement d'une mémoire présentant une organisation série-parallèle.

Dans les mémoires à bulles décrites ci-dessus, la fabrication d'une bulle sur une boucle majeure, correspondant à l'écriture d'une information, est réalisée en appliquant un courant élevé à un conducteur, généralement en forme de U (figure 1), traversant les motifs de propagation constituant la boucle majeure. Cette opération généralement connue sous le nom de nucléation est réalisée lorsque la bulle se trouve dans une cavité définie entre deux motifs adjacents.

Après nucléation, la bulle est ensuite propagée, par application du champ tournant $H_T$, sur la boucle majeure vers les portes de transfert afin de transférer la bulle de la boucle majeure vers une boucle mineure. Ces portes de transfert sont généralement réalisées par un conducteur en forme de U. L'application d'une impulsion de courant à ce conducteur permet d'étendre chaque bulle entre les sommets des motifs de propagation de la boucle majeure et ceux correspondants de la boucle mineure et ensuite, l'arrêt de l'impulsion de courant entraîne la contraction des bulles sur la boucle mineure. Le transfert est alors réalisé. L'information est ainsi stockée sur la boucle mineure.

La lecture de cette information se fait en transférant une bulle magnétique d'une boucle mineure vers une boucle majeure. Le transfert se fait comme précédemment.

Pour effectuer la lecture d'une information de manière non destructive, la bulle correspondante doit être dupliquée. Dans le cas d'une duplication bulle par bulle, cette duplication est réalisée au moyen d'un conducteur (figure 1) traversant la boucle majeure, auquel on applique une impulsion de courant, entraînant l'élongation de la bulle de part et d'autre des chemins de propagation, puis la coupure de cette bulle en deux. L'une de ces bulles, transférée sur un chemin de détection, pourra être détectée de façon destructive par un détecteur de type magnéto-résistif, généralement à base de fer et de nickel, et l'autre bulle sera ré-injectée dans la boucle mineure à la place occupée par la bulle d'origine.

Une mémoire à bulles fonctionnant sur ce principe a été décrite dans un brevet américain n° 4 253 159, déposé le 3 décembre 1979 et intitulé « Ion-implanted bubble memory with replicate port ». Dans ce brevet, on utilise une seule boucle majeure et des motifs de propagation non implantés.

Les mémoires à bulles magnétiques comportant comme motifs de propagation des motifs non implantés et présentant une structure et un fonctionnement tels que ceux décrits précédemment (voir brevet américain), possèdent deux limitations importantes qui sont le temps d'accès à l'information et le débit de l'information.

Pour résoudre ces problèmes, une solution consiste à diviser la mémoire à bulles en plusieurs dispositifs ou éléments de mémoire semblables fonctionnant en parallèle sur la même puce ; ces dispositifs ou éléments indépendants présentent une organisation quelconque par exemple une organisation série parallèle ou une organisation majeure-mineure. Le débit des informations, qui est proportionnel au nombre de détecteurs de la mémoire, est alors augmenté et le temps d'accès à l'information diminué étant donné que la zone mémoire de chaque dispositif est réduite. Une telle structure de mémoire est décrite dans un article de P. K. GEORGE, H. S. GILL, R. H. NORTON, G. F. REYLING, A. M. TUXFORD paru dans Intermag Conference Digest, GRENOBLE 1971, Paper n° 9-1. Dans cette mémoire les motifs de propagation sont en permalloy.

Bien que cette solution permette d'améliorer les performances de la mémoire (débit, temps d'accès), cette organisation ou structure de la mémoire nécessite un nombre de circuits de commande proportionnel au nombre de dispositifs ou éléments de mémoire contenu dans la puce et notamment en ce qui concerne la multiplicité des circuits de détection des bulles ; l'emploi de plusieurs circuits de commande augmente considérablement le coût de fabrication de la mémoire.

En outre, il est connu par le document GB-A-2 094 082 une mémoire à bulles magnétiques à motifs non implantés comportant des conducteurs électriques pour engendrer des bulles, alignés, et des moyens électriques pour détecter des bulles, disposés selon des directions formant entre elles des angles de 45°.

La présente invention a justement pour objet une mémoire à bulles magnétiques utilisant comme motifs de propagation des bulles des motifs non implantés permettant de remédier aux inconvénients donnés ci-dessus.

De façon plus précise, l'invention se rapporte à une mémoire à bulles comprenant, reliés électriquement entre eux, 3n dispositifs de mémoire semblables réalisés sur une même puce de circuit, n étant un entier positif, caractérisée en ce que chaque dispositif comporte des boucles mineures servant au stockage des bulles, au moins une boucle majeure servant de boucle d'accès aux boucles mineures, des premiers conducteurs électriques permettant le transfert des bulles des boucles mineures vers la boucle majeure et réciproquement, les premiers conducteurs des 3n dispositifs, identiques et disposés selon une même direction, recevant simultanément une même impulsion de courant afin de transférer simultanément sur les différents dispositifs de mémoire des bulles magnétiques, des boucles mineures vers la boucle majeure correspondante et réciproquement, un second conducteur électrique permettant d'engendrer des bulles sur la boucle majeure, et un moyen électrique permettant de détecter les bulles sur la boucle majeure, ce moyen étant constitué par un troisième conducteur électrique d'extension-contraction des bulles et par un élément magnéto-résistifs, les seconds conducteurs des 3n dispositifs étant identiques, reliés électriquement en série et disposés suivant des premières directions faisant entre elles un angle de 120°, ces premières directions correspondant aux trois axes cristallographiques, coplanaires, de facile aimantation de la couche de matériau magnétique monocristallin dans laquelle sont réalisés les motifs de propagation, les moyens électriques des 3n dispositifs étant non implantés identiques, reliés électriquement en série et disposés suivant des secondes directions faisant entre elles un angle de 120°, les bulles des 3n dispositifs étant soumises à l'action d'un unique champ tournant permettant la propagation des bulles le long des motifs non implantés.

Dans une variante de l'invention, le nombre de dispositifs de mémoire est 6n, les seconds conducteurs sont regroupés en groupes de trois et orientés de façon que les seconds conducteurs d'un même groupe soient disposés selon des premières directions faisant entre elles un angle de 120°, et les moyens électriques sont disposés suivant des secondes directions faisant entre elles un angle de 60°.

Le résultat de cet assemblage et notamment de l'orientation des moyens de détection des bulles est une mémoire à bulles dont l'organisation est identique à celle des mémoires à bulles comportant un seul dispositif de mémoire mais qui comprend, si N est le nombre de dispositifs de mémoire, N fois plus de boucles mineures et N fois plus de boucles majeures et dont le débit des informations est N fois plus grand que ceux des mémoires à bulles à un seul dispositif de mémoire.

Pour que cette mémoire fonctionne correctement, il est préférable que les bulles qui se propagent sur les boucles majeures soient espacées de un, deux ou quatre pas les unes des autres ; un pas correspond à une période de rotation du champ tournant auquel sont soumises les bulles magnétiques.

Ces dispositifs de mémoire peuvent comprendre aussi un quatrième conducteur électrique permettant de dupliquer les bulles magnétiques, ces quatrièmes moyens étant identiques et disposés selon une même direction.

Selon un mode préféré de réalisation de la mémoire de l'invention, les dispositifs de mémoire sont au nombre de trois ou de six.

Selon un autre mode préféré de réalisation de la mémoire de l'invention, les seconds moyens sont reliés électriquement entre eux et en série.

Selon un autre mode préféré de réalisation de la mémoire de l'invention, les conducteurs électriques d'extension-contraction des bulles et les éléments magnéto-résistifs des troisièmes moyens sont respectivement reliés électriquement entre eux et en série.

L'invention a aussi pour objet un procédé permettant de commander les différents conducteurs et moyens électriques constituant la mémoire à bulles telle que définie précédemment.

D'autres caractéristiques et avantages de l'invention apparaîtront au cours de la description qui va suivre donnée à titre d'exemple, en se référant aux dessins annexés sur lesquels :

la figure 1, déjà décrite, représente schématiquement une partie d'une mémoire à bulles au niveau de l'un des conducteurs électriques la constituant,

la figure 2, déjà décrite, illustre le principe de propagation des bulles dans une mémoire à bulles,

la figure 3 est un schéma synoptique de la mémoire à bulles selon l'invention,

la figure 4 illustre la connexion et la disposition des différent générateurs de bulles de la mémoire selon l'invention,

les figures 5a et 5b représentent les signaux de commande relatifs aux générateurs de bulles, la figure 5a dans le cas de trois générateurs et la figure 5b dans le cas de six générateurs,

la figure 6 illustre la connexion et la disposition des différents détecteurs de bulles de la mémoire selon l'invention,

la figure 7 illustre un mode de positionnement des détecteurs de bulles au niveau des motifs de propagation associés, et

les figures 8a et 8b représentent les signaux de commande relatifs aux détecteurs de bulles, la figure 8a dans le cas de trois détecteurs et la figure 8b dans le cas de six détecteurs.

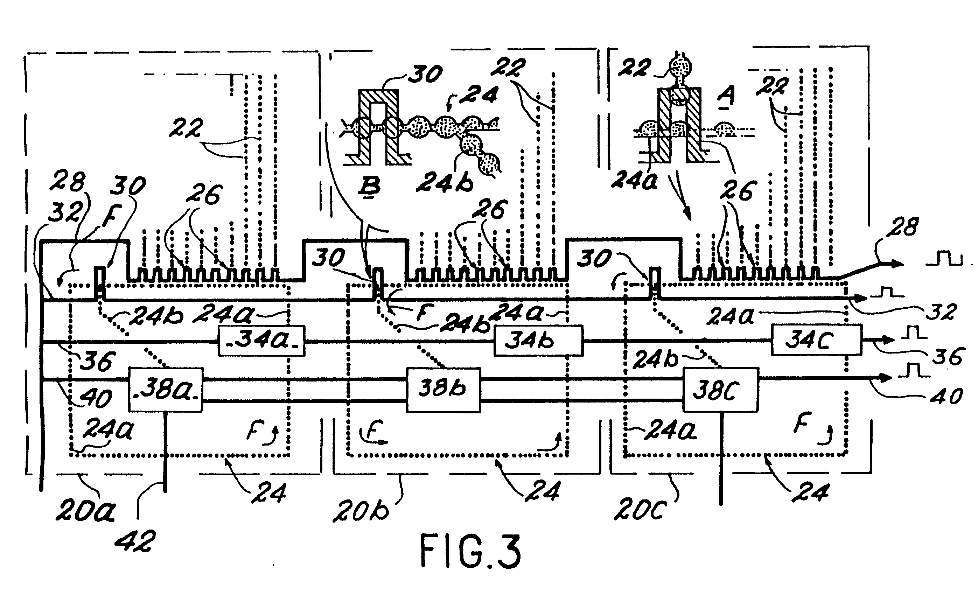

Sur la figure 3, on a représenté un schéma synoptique d'une mémoire à bulles selon l'invention. En vue d'une simplification, les différents éléments (conducteurs, motifs de propagation) entrant dans la constitution de la mémoire ont été représentés dans le même plan.

Cette mémoire à bulles comprend 3n ou 6n dispositifs de mémoire semblables, n étant un nombre entier positif. De préférence ces dispositifs sont au nombre de trois ou de six (n étant égal à 1). Ces dispositifs 20a, 20b, 20c réalisés sur une même puce de circuit, présentent une organisation quelconque. Ils présentent par exemple, comme représenté sur cette figure une organisation majeure-mineure, mais bien entendu toute autre organisation peut être envisagée (organisation série-parallèle notamment). Ces différents dispositifs de mémoire sont reliés électriquement entre eux.

Chaque dispositif de mémoire 20a, 20b ou 20c comprend plusieurs boucles mineures 22 servant au stockage des bulles magnétiques, non représentées. Ces boucles mineures 22 sont toutes disposées les unes à côté des autres. Ces trois dispositifs de même structure, comportent notamment le même nombre de boucles mineures 22, comme représenté sur la figure 3. A ces boucles mineures 22 est associée, pour chaque dispositif de mémoire, une seule boucle majeure 24 servant de boucle d'accès aux boucles mineures 22. Cette boucle majeure 24 qui est orientée perpendiculairement aux boucles mineures 22 correspondantes, est utilisée aussi bien pour l'écriture que pour la lecture des informations.

Les différentes flèches f représentées illustrent le sens de propagation des bulles magnétiques dans la mémoire.

Le transfert des bulles magnétiques, des boucles mineures 22 vers la boucle majeure 24 associée (lecture) et réciproquement (écriture), est assuré, pour chaque dispositif mémoire 20a, 20b ou 20c par des portes de transfert 26 bidirectionnelles. Ces portes de transfert 26, en nombre égal au nombre de boucles mineures 22, sont formées, chacune, par un conducteur électrique, généralement en forme de U (voir partie grossie A de la figure).

Conformément à l'invention, les portes de transfert 26 des trois dispositifs de mémoire 20a, 20b et 20c sont reliées électriquement entre elles ; la connexion de ces différentes portes est assurée par le conducteur 28. Elles peuvent être reliées en série, comme représenté sur la figure 3, ou bien en parallèle. De plus, ces portes de transfert sont identiques et disposées selon une même direction.

Le transfert des bulles magnétiques, au moyen des portes de transfert 26, est assuré en appliquant sur ces portes des courants identiques, c'est-à-dire la même impulsion de courant. Cette impulsion de courant est appliquée simultanément sur toutes les portes de transfert de tous les
dispositifs de mémoire de façon à effectuer le
transfert simultanément sur tous ces dispositifs.
Cette impulsion de courant peut présenter soit un
seul niveau d'amplitude, soit plusieurs niveaux
d'amplitude de mêmes signes ou de signes
contraires.

Il est à noter que la connexion électrique et la
commande des portes de transfert 26 sont les
mêmes, quel que soit le nombre, 3n ou 6n et de
préférence trois ou six, de dispositifs de mémoire
constituant la mémoire selon l'invention.

Par ailleurs, chaque dispositif de mémoire 20a,
20b ou 20c comprend un conducteur 30 permettant de dédoubler ou dupliquer les bulles magnétiques. Cette duplication est généralement effectuée pour aller lire les informations contenues
dans les boucles mineures 22. La lecture d'une
information se fait en extrayant des bulles magnétiques des boucles mineures 22, par l'intermédiaire des portes de transfert 26. Ces bulles sont
ensuite acheminées vers le conducteur 30 afin
d'être dupliquées. Une des bulles obtenues par
duplication sera acheminée, par le chemin de
propagation 24a, sur la boucle mineure 22 à la
place occupée par la bulle d'origine et l'autre
bulle sera acheminée par le chemin de propagation 24b afin d'être détectée de manière destructive. Chaque conducteur de duplication 30, situé
au niveau de la boucle majeure 24 correspondante, présente par exemple la forme d'un U (voir
partie grossie B de la figure).

Selon l'invention, les conducteurs de duplication 30 des trois dispositifs de mémoire 20a, 20b
et 20c sont reliés électriquement entre eux ; la
connexion des trois conducteurs de duplication
30 est assurée par le conducteur 32. Ces conducteurs peuvent être reliés en série, comme représenté sur la figure 3, ou bien en parallèle. De plus,
ils sont identiques et orientés selon une même
direction.

La duplication des bulles magnétiques, au
moyen des conducteurs 30, est assurée en appliquant sur ces conducteurs des courants identiques, c'est-à-dire la même impulsion de courant.
Cette impulsion de courant est appliquée simultanément sur les trois conducteurs 30 de façon à
effectuer une duplication simultanée sur les trois
dispositifs. Cette impulsion de courant peut présenter soit un seul niveau d'amplitude, soit plusieurs niveaux d'amplitude de mêmes signes ou
de signes contraires.

Il est à noter que la connexion électrique et la
commande des conducteurs de duplication 30
sont les mêmes, quel que soit le nombre, 3n ou 6n
et de préférence trois ou six, de dispositifs de
mémoire constituant la mémoire selon l'invention.

Chaque dispositif de mémoire 20a, 20b ou 20c
comprend, de plus, un générateur de bulles
magnétiques 34a, 34b ou 34c fonctionnant notamment sur le principe de la nucléation. Chaque
générateur ou nucléateur situé au niveau de la
boucle majeure 24 correspondante, est constitué
d'un conducteur électrique auquel peuvent être appliquées des impulsions électriques entraînant
la formation de bulles.

Selon l'invention, les générateurs 34a, 34b et
34c, respectivement des trois dispositifs de
mémoire 20a, 20b et 20c, sont reliés électriquement entre eux et de préférence en série, la
connexion de ces trois générateurs étant assurée
par le conducteur 36.

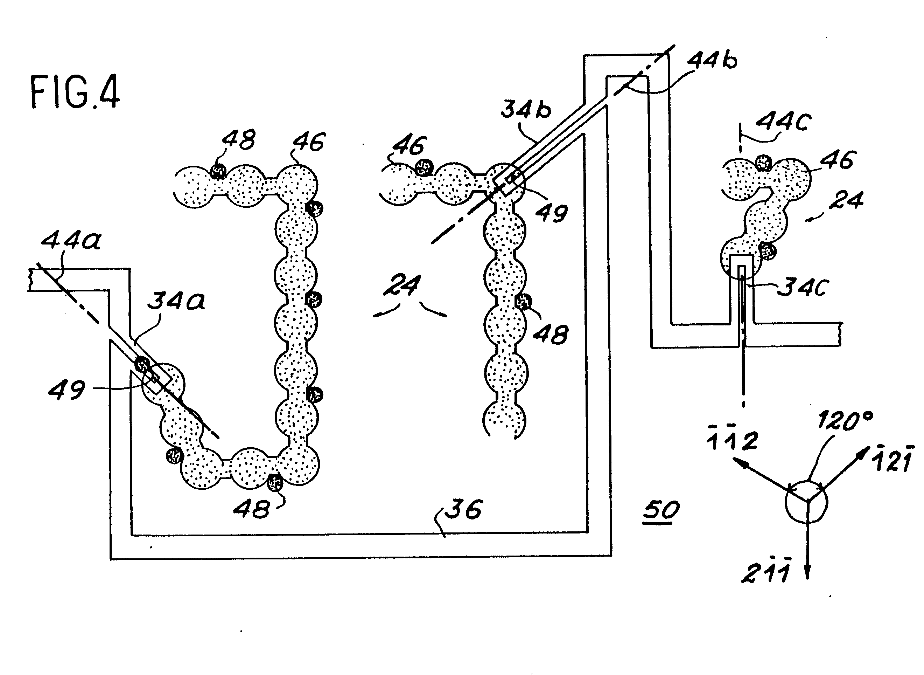

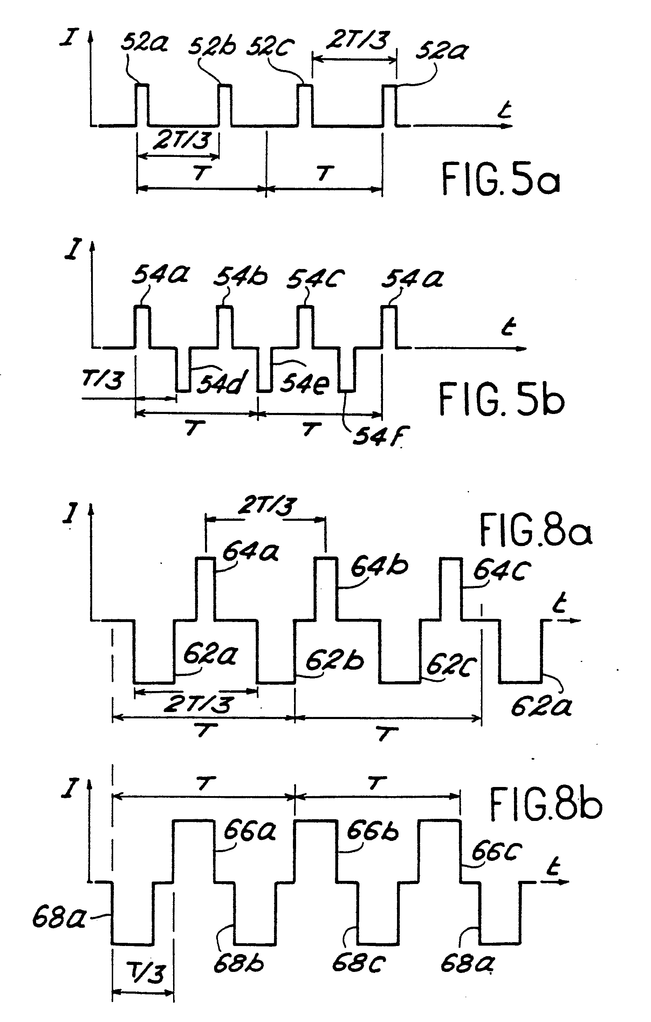

L'organisation et la commande de ces générateurs seront décrites de façon plus détaillée
ultérieurement en référence aux figures 4, 5a et
5b.

Chaque dispositif de mémoire 20a, 20b ou 20c
comprend, encore, un détecteur de bulles magnétiques 38a, 38b ou 38c fonctionnant sur le principe de la détection destructive. Chaque détecteur, situé au niveau de la boucle majeure 24
correspondante, est constitué notamment d'un
conducteur électrique, dit conducteur d'extension-contraction, et d'un élément conducteur de
préférence magnéto-résistif à base de fer et de
nickel. Lorsque ce dernier est parcouru par un
courant continu, l'application d'impulsions de
courant sur le conducteur d'extension-contraction correspondant entraîne la détection des bulles.

Selon l'invention, les détecteurs 38a 38b et 38c,
respectivement des trois dispositifs de mémoire
20a, 20b et 20c sont reliés électriquement entre
eux et de préférence en série ; la connexion des
conducteurs d'extension-contraction est réalisée
par le conducteur 40 et la connexion des éléments
conducteurs magnéto-résistifs par le conducteur
42.

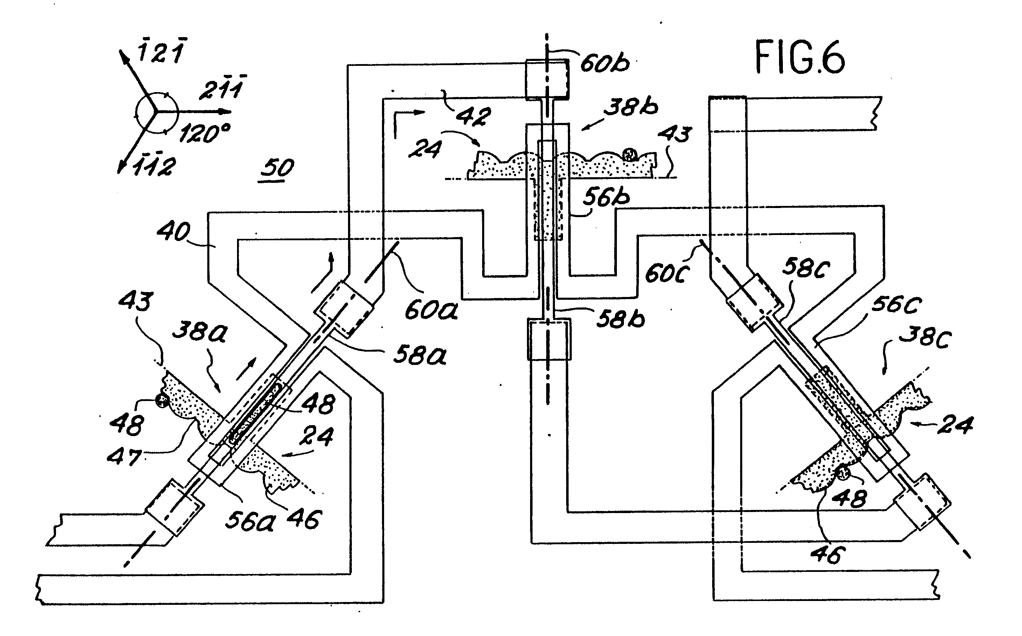

L'organisation et la commande de ces détecteurs seront décrites ultérieurement de façon
plus détaillée en référence aux figures 6, 7, 8a et
8b.

Une telle organisation de mémoire, bien
entendu applicable à une mémoire comportant
six dispositifs mémoire semblables, permet
d'augmenter le débit de l'information. Par ailleurs,
cette mémoire nécessite pour son fonctionnement le même nombre de conducteurs électriques, tels que les conducteurs 28, 32, 36, 40 et 42,
qu'en nécessite une mémoire à bulles constituée
d'un seul dispositif de mémoire.

Pour que la mémoire à bulles décrite ci-dessus
fonctionne correctement, il est préférable que les
bulles qui se propagent sur les boucles majeures
soient espacées les unes des autres de un, deux
ou quatre pas, une bulle magnétique faisant un
pas pendant une période de rotation du champ
magnétique tournant $H_T$.

Sur la figure 4, on a représenté l'organisation
des générateurs de bulles magnétiques, dans le
cas de trois générateurs, donc d'une mémoire à
bulles comportant trois dispositifs de mémoire
20a, 20b et 20c (figure 3). Les générateurs, respectivement 34a, 34b et 34c, sont constitués par des
conducteurs électriques pouvant présenter chacun un axe de symétrie, respectivement 44a, 44b
et 44c. Ces conducteurs, présentant notamment
la forme d'un U, sont reliés électriquement entre
eux, et de préférence en série, par le conducteur 36.

Sur cette figure, on a de plus, représenté les motifs de propagation non implantés contigus 46 des boucles majeures 24 correspondantes (figure 3), situés au niveau de chaque générateur. Ces motifs 46, autour desquels s'effectue le déplacement de bulles magnétiques 48, soumises à un champ magnétique plan tournant et continu $H_T$, sont définis par implantation ionique dans la partie supérieure de la couche de matériau magnétique 50 monocristallin, contenant les bulles.

En vue d'une simplification, les différents éléments de la mémoire (conducteurs, motifs de propagation) ainsi que les bulles ont été représentés dans le même plan.

Comme représenté sur cette figure, la génération des bulles magnétiques 48 se distingue sur chaque dispositif de mémoire 20a, 20b ou 20c par l'orientation des générateurs 34a, 34b et 34c. La génération des bulles magnétiques, au moyen des générateurs, ne peut se faire que s'il existe une relation entre la phase de l'impulsion électrique appliquée aux générateurs et l'orientation de ces générateurs ; la phase de l'impulsion est la phase du champ magnétique $H_T$ au moment où on applique ladite impulsion. Ceci est réalisé en utilisant des générateurs dont la marge ou tolérance de phase est étroite. Cette marge de phase est de ± 20°.

Usuellement, la formation des bulles magnétiques s'effectue dans les cavités ou creux (figure 1) définies entre deux motifs de propagation adjacents. Dans l'invention, ce type de formation des bulles ne peut être employé étant donné que la marge de phase des générateurs correspondants est beaucoup trop grande (± 80°).

Selon l'invention, les trois générateurs 34a, 34b et 34c sont identiques et orientés suivant des directions faisant entre elles des angles de 120°. Autrement dit, lorsque les générateurs présentent des axes de symétrie respectivement 44a, 44b et 44c, ces trois axes font entre eux un angle de 120°. Ces axes de symétrie peuvent par exemple être dirigés selon les trois axes cristallographiques coplanaires équivalents, de facile aimantation, de la couche de matériau magnétique 50 formant entre eux un angle de 120°. Pour une couche de matériau 50, épitaxiée sur un substrat suivant la direction 111, les trois axes cristallographiques sont notamment les axes 112, 121 et 211, comme représenté en bas à droite de la figure.

La formation de bulles magnétiques, au moyen des générateurs 34a, 34b et 34c, est assurée en appliquant le même signal électrique sur les trois conducteurs électriques les constituant. Ce signal comporte plusieurs impulsions de courant, présentant par exemple un seul niveau d'amplitude et permettant de commander successivement les trois générateurs. Comme représenté sur la figure 5a, montrant l'amplitude des impulsions de courant I en fonction du temps t, ces impulsions présentent la même polarité et sont espacées les unes des autres d'un temps égal à q/3 période de rotation T du champ magnétique tournant $H_T$, q étant le nombre de pas séparant les bulles magnétiques 48 les unes des autres sur les boucles majeures 24 ; en particulier lorsque les bulles sont espacées de deux pas (q = 2), les impulsions de courant sont espacées d'un temps égal aux 2/3 de la période de rotation du champ $H_T$. Les impulsions 52a, 52b et 52c sont appliquées respectivement aux conducteurs électriques constituant les trois générateurs de bulles magnétiques 34a, 34b et 34c.

Par ailleurs, comme représenté sur la figure 4, la formation des bulles magnétiques, au moyen des trois générateurs, est réalisée de préférence à partir des sommets 49 des motifs de propagation 46 associés à chaque générateur.

Dans le cas de six générateurs, donc d'une mémoire à bulles comportant six dispositifs de mémoire semblables, les six générateurs identiques sont regroupés en deux groupes de trois générateurs, les deux groupes étant reliés électriquement en série. Selon l'invention, les générateurs d'un même groupe sont connectés et orientés comme représenté sur la figure 4, c'est-à-dire de façon que les trois axes de symétrie des conducteurs électriques constituant ces générateurs fassent entre eux un angle de 120°. Ces axes de symétrie peuvent être notamment dirigés suivant les axes cristallographiques coplanaires équivalents, de facile aimantation (112, 121, 211), de la couche de matériau contenant les bulles magnétiques.

La formation des bulles magnétiques, ou nucléation, au moyen de six générateurs, est assurée en appliquant le même signal électrique sur les six conducteurs électriques les constituant. Ce signal comporte plusieurs impulsions de courant, présentant un seul niveau d'amplitude et permettant de commander successivement les six générateurs. Comme représenté sur la figure 5b, montrant l'amplitude des impulsions de courant I en fonction du temps t, ces impulsions de courant sont espacées les unes des autres d'un temps égal à q/6 périodes de rotation T du champ magnétique tournant $H_T$, q étant le nombre de pas séparant les bulles magnétiques les unes des autres sur les boucles majeures 24 ; en particulier, lorsque les bulles sont espacées de deux pas, les impulsions sont espacées d'un temps égal à 1/3 de la période de rotation du champ $H_T$.

De plus, les deux groupes de générateurs sont commandés en alternance et les impulsions de courant, appliquées sur les trois générateurs d'un même groupe, sont de polarité opposée à celles appliquées aux trois générateurs de l'autre groupe ; les impulsions 54a, 54b et 54c, de même polarité, sont appliquées respectivement sur les trois générateurs de bulles magnétiques, par exemple 34a, 34b et 34c (figure 4), appartenant à un même groupe et les impulsions 54d, 54e et 54f, de polarité inverse à celle des impulsions 54a, 54b et 54c, sont appliquées respectivement sur les trois générateurs de l'autre groupe.

Comme précédemment, la formation des bulles magnétiques est réalisée de préférence à partir des sommets 49 des motifs de propagation 46 associés à chaque générateur (figure 4).

Sur la figure 6, on a représenté l'organisation des détecteurs de bulles magnétiques dans le cas de trois détecteurs, donc d'une mémoire à bulles comportant trois dispositifs de mémoire 20a, 20b et 20c (figure 3). Les détecteurs 38a, 38b et 38c sont constitués chacun d'un conducteur électrique d'extension-contraction respectivement 56a, 56b et 56c présentant notamment la forme de U, et d'un élément conducteur de type magnéto-résistif respectivement 58a, 58b et 58c. Les conducteurs d'extension-contraction sont reliés électriquement entre eux, et de préférence en série, au moyen du conducteur 40 et les éléments magnéto-résistifs sont reliés électriquement entre eux, et de préférence en série, au moyen du conducteur 42. Ces détecteurs 38a, 38b et 38c peuvent présenter chacun un axe de symétrie respectivement 60a, 60b, 60c. Ces axes correspondent à la fois aux axes de symétrie des conducteurs d'extension-contaction et aux axes de symétrie des éléments magnétorésistifs.

Sur cette figure, on a de plus, représenté les motifs de propagation non implantés 46 des boucles majeures 24 correspondantes (figure 3), situés au niveau de chaque détecteur, ainsi que les bulles magnétiques 48 qui se déplacent le long de ces motifs.

Comme pour les générateurs de bulles magnétiques (figure 4), les détecteurs 38a, 38b et 38c se distinguent les uns des autres par leur orientation sur les dispositifs de mémoire correspondants.

Selon l'invention, les trois détecteurs 38a, 38b et 38c sont identiques et orientés suivant des directions faisant entre elles des angles de 120°. Autrement dit, lorsque ces détecteurs présentent des axes de symétrie respectivement 60a, 60b et 60c, ces trois axes font entre eux un angle de 120°.

On rappelle que la détection de façon destructive d'une bulle magnétique consiste à allonger tout d'abord la bulle, en excitant électriquement le conducteur d'extension-contraction, puis à détecter la bulle, à l'aide de l'élément magnéto-résistif parcouru par un courant constant et à contracter la bulle, en excitant électriquement le conducteur d'extension-contraction. La détection d'une bulle magnétique par l'élément magnéto-résistif correspond à la transformation de cette bulle en un signal électrique. Après contraction de la bulle, celle-ci peut être annihilée ou bien renvoyée en direction des boucles mineures.

Afin d'éviter la formation de bulles magnétiques (nucléation) lors de la phase d'extension de celles-ci, les motifs de propagation 46 situés en regard de chaque détecteur 38a, 38b ou 38c, peuvent être alignés suivant un axe 43, parallèle à l'un des axes cristallographiques coplanaires équivalents, de facile aimantation, de la couche de matériau 50 contenant les motifs de propagation 46. Comme représenté sur la figure 6, ces trois axes cristallographiques peuvent être par exemple les axes 112, 121 et 211 pour une couche de matériau 50, épitaxiée suivant une direction 111.

Comme l'axe d'alignement 43 des motifs de propagation est généralement disposé suivant une direction perpendiculaire à l'axe de symétrie 60a, 60b ou 60c du détecteur qui correspond, il s'ensuit que ces axes de symétrie sont orientés perpendiculairement auxdits axes cristallographiques coplanaires, de facile aimantation. Dans une telle disposition, l'extension des bulles magnétiques 48 se fait à partir de l'une des cavités 47, délimitée entre deux motifs adjacents 46, comme représenté sur la figure 6. En particulier l'axe de symétrie 60a, 60b ou 60c des détecteurs associés à ces motifs de propagation, passe par les deux cavités délimitées par deux motifs adjacents correspondants.

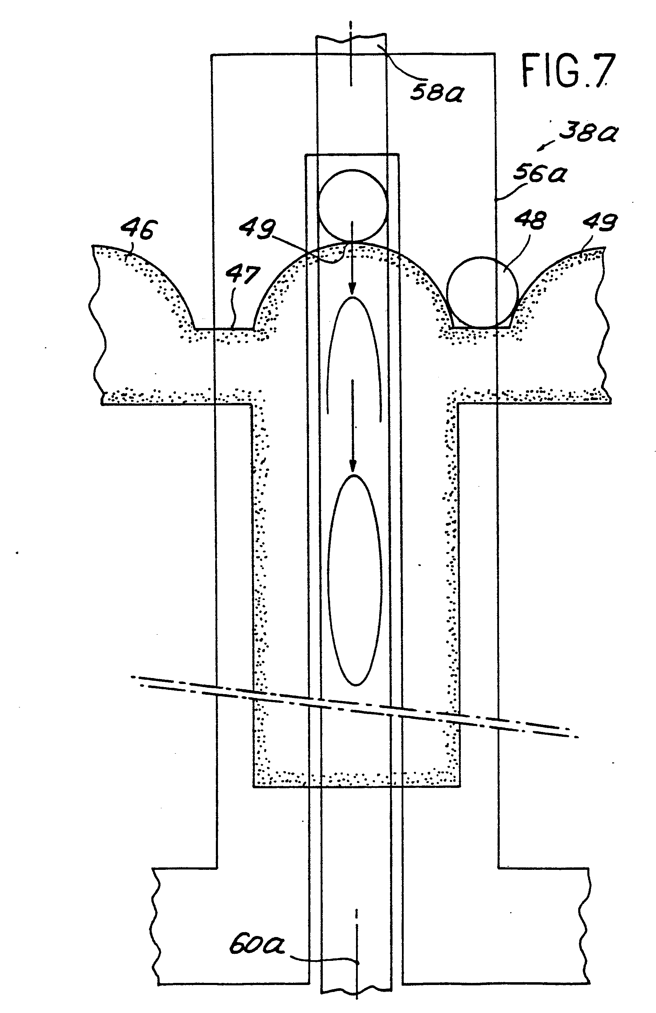

Une autre solution consiste, comme représenté sur la figure 7, à étendre les bulles magnétiques 48 à partir de l'un des sommets 49 des motifs de propagation 46 associés à chaque détecteur. Dans ce cas, peu importe l'orientation des motifs de propagation par rapport aux axes cristallographiques, de facile aimantation, de la couche de matériau contenant lesdits motifs de propagation.

La détection des bulles magnétiques au moyen des trois détecteurs 38a, 38b et 38c est assurée en appliquant le même signal électrique sur les trois conducteurs d'extension-contraction les constituant, les éléments magnéto-résistifs étant alimentés en courant continu. Ce signal comporte plusieurs impulsions de courant permettant d'exciter successivement les trois conducteurs d'extension-contraction. La détection proprement dite des bulles au moyen des trois éléments magnéto-résistifs est aussi réalisée successivement par lesdits éléments.

La commande d'un détecteur consiste notamment à appliquer au conducteur d'extension-contraction le constituant deux impulsions de courants, présentant par exemple la même amplitude mais présentant des polarités inverses. Elles peuvent présenter des durées différentes ou identiques. Sur la figure 8a, on a représenté l'amplitude des impulsions de courant I en fonction du temps t.

Les impulsions de courant 62a, 62b et 62c, de même polarité, appliquées respectivement sur les trois conducteurs d'extension-contraction 56a, 56b et 56c permettent d'allonger les bulles magnétiques 48 à détecter sur une longueur d'environ 100 µ dans les espaces prévus à cet effet. De même, les impulsions 64a, 64b et 64c, de polarité inverse de celle des impulsions 62a, 62b et 62c, appliquées respectivement sur les trois conducteurs d'extension-contraction 56a, 56b et 56c permettent de contracter les bulles magnétiques 48 précédemment allongées.

Comme représenté sur la figure 8a, les impulsions de courant 62a, 62b et 62c relatives à l'extension des bulles excitant respectivement les trois conducteurs d'extension-contraction sont espacées les unes des autres d'un temps égal à q/3 période de rotation T du champ magnétique tournant $H_T$, q étant le nombre de pas séparant les bulles magnétiques 48 les unes des autres sur les boucles majeures 24 ; par exemple lorsque les bulles sont espacées de deux pas (q = 2), ces impulsions sont espacées d'un temps égal aux 2/3 de la période de rotation du champ $H_T$.

De même, les impulsions de courant 64a, 64b et 64c, relatives à la contraction des bulles excitant les trois conducteurs d'extension-contraction sont espacées les unes des autres d'un temps égal à q/3 période de rotation T du champ magnétique tournant $H_T$, q étant le nombre de pas séparant les bulles magnétiques 48 les unes des autres sur les boucles majeures 24. Le temps séparant les impulsions relatives à l'allongement des bulles et celles relatives à la contraction des bulles peut être quelconque.

En ce qui concerne la détection proprement dite, au moyen des éléments magnéto-résistifs, celle-ci est réalisée en appliquant un courant continu sur les trois éléments reliés en série. La présence d'une bulle dans l'un des détecteurs entraîne la variation de la résistance de l'élément magnéto-résistif. Le signal électrique qui en résulte apparaît seulement dans une portion du cycle de rotation du champ tournant $H_T$. Cette détection est réalisée successivement sur les trois éléments magnéto-résistifs. Les signaux de détection relatifs aux trois éléments 58a, 58b et 58c sont espacés les uns des autres d'un temps égal à q/3 période de rotation T du champ tournant $H_T$. L'utilisation d'éléments magnéto-résistifs à base de fer et de nickel facilite la détection des bulles magnétiques étant donné que ces éléments présentent un bon rapport signal/bruit et une faible impédance ; ceci facilite notamment leur connexion en série (figure 6).

Dans le cas de six détecteurs, donc d'une mémoire à bulles comportant six dispositifs de mémoire semblables, les six détecteurs identiques sont regroupés en deux groupes de trois détecteurs, les deux groupes étant reliés électriquement en série ; autrement dit les deux groupes de conducteurs d'extension-contraction d'une part, et les deux groupes d'éléments magnéto-résisitifs d'autre part, sont reliés en série.

Selon l'invention, les détecteurs d'un même groupe sont connectés et orientés comme représenté sur la figure 6, c'est-à-dire de façon que les trois axes de symétrie de ces détecteurs fassent entre eux un angle de 120°. De plus, les deux groupes de détecteurs sont orientés l'un par rapport à l'autre de façon que les six axes de symétrie fassent entre eux un angle de 60°.

Les six axes de symétrie peuvent être par exemple dirigés perpendiculairement aux trois axes cristallographiques coplanaires équivalents, de facile aimantation, de la couche de matériau 50 contenant les motifs de propagation ; autrement dit les axes d'alignement des motifs de propagation, situés en regard de chaque détecteur peuvent être orientés parallèlement auxdits axes cristallographiques, les axes d'alignement étant perpendiculaires aux axes de symétrie des détecteurs correspondants. Les axes cristallographiques peuvent être notamment les axes 112, 121 et 211 pour une couche de matériau épitaxiée selon une direction 111. Dans une telle disposition des détecteurs, l'extension des bulles magnétiques se fait, comme dans le cas de trois détecteurs, à partir de l'une des cavités, délimitée entre deux motifs adjacents (figure 6).

Comme précédemment, l'extension des bulles magnétiques peut aussi avoir lieu à partir de l'un des sommets des motifs de propagation associés à chaque détecteur (figure 7), pour éviter le problème de la nucléation et ce, quelle que soit l'orientation de ces motifs par rapport auxdits axes cristallographiques.

La détection des bulles magnétiques, au moyen des six détecteurs, est assurée comme précédemment en appliquant le même signal électrique sur les six conducteurs d'extension-contraction les constituant, les éléments magnéto-résistifs étant alimentés en courant continu. Ce signal comporte plusieurs impulsions de courant permettant d'exciter successivement les six conducteurs d'extension-contraction. La détection proprement dite des bulles au moyen des six éléments magnéto-résistifs est aussi réalisée successivement par lesdits éléments.

La commande d'un détecteur consiste à appliquer au conducteur d'extension-contraction le constituant deux impulsions de courant, présentant notamment la même amplitude mais présentant des polarités inverses. Comme représenté sur la figure 8b, montrant l'amplitude des impulsions de courant I en fonction du temps t, les impulsions 66a, 66b et 66c, de même polarité, sont appliquées respectivement sur les conducteurs d'extension-contraction, par exemple 56a, 56b et 56c (figure 6), appartenant à un même groupe de détecteurs, pour permettre l'allongement des bulles magnétiques 48 à détecter à l'aide de ces détecteurs. Ces mêmes impulsions sont appliquées respectivement sur les conducteurs d'extension-contraction appartenant à l'autre groupe de détecteurs pour permettre la contraction d'autres bulles magnétiques.

De même, les impulsions 68a, 68b et 68c, de polarité inverse de celle des impulsions 66a, 66b et 66c, sont appliquées respectivement sur les conducteurs d'extension-contraction, par exemple 56a, 56b et 56c (figure 6), appartenant à un même groupe de détecteurs, pour permettre la contraction de bulles magnétiques 48 précédemment allongées. Ces mêmes impulsions sont appliquées respectivement sur les conducteurs d'extension-contraction appartenant à l'autre groupe de détecteurs, pour permettre l'allongement d'autres bulles magnétiques.

Il est à noter que les détecteurs doivent être conçus de manière que l'amplitude et la durée de l'allongement des bulles magnétiques soient égales respectivement à l'amplitude et à la durée de la contraction de ces mêmes bulles. Il s'ensuit que les impulsions de courant servant à l'allongement des bulles, et les impulsions de courants, servant à la contraction de ces bulles, doivent présenter la même amplitude et la même durée, comme représenté sur la figure 8b.

Selon l'invention, les impulsions de courant, relatives à l'extension des bulles, excitant respectivement les trois conducteurs d'extension-contraction d'un même groupe de détecteurs, sont espacées les unes des autres d'un temps égal à q/3 période de rotation T du champ magnétique tournant $H_T$, lorsque les bulles magnétiques 48 sont espacées les unes des autres de q pas sur les boucles majeures 24. Il en est de même pour les impulsions de courant relatives à la contraction des bulles, excitant respectivement les trois conducteurs d'extension-contraction du même groupe. En conséquence toutes les impulsions de courant 66a, 68a, 66b, 68b, 66c et 68c appliquées successivement sur les trois conducteurs d'extension-contraction d'un même groupe sont espacées d'un temps égal à q/6 période de rotation du champ tournant, c'est-à-dire que les impulsions relatives à l'extension des bulles pour les six détecteurs et que les impulsions relatives à la contraction des bulles pour les six détecteurs sont espacées réciproquement de q/6 période de rotation du champ $H_T$.

En ce qui concerne la détection proprement dite, au moyen des éléments magnéto-résistifs, celle-ci est réalisée comme précédemment, c'est-à-dire successivement sur les six éléments. Les signaux de détection relatifs aux trois éléments d'un même groupe sont espacés les uns des autres d'un temps égal à q/3 période de rotation du champ, c'est-à-dire que les signaux de détection relatifs aux six éléments sont espacés les uns des autres d'un temps égal à q/6 période de rotation dudit champ.

La mémoire à bulles magnétiques à motifs non implantés et son procédé de commande, tels que décrits précédemment, permettent d'augmenter considérablement le débit de l'information contenue dans la mémoire par rapport aux mémoires à bulles de l'art antérieur.

## Revendications

1. Mémoire à bulles magnétiques comportant des motifs contigus de propagation des bulles et reliés électriquement entre eux, 3n dispositifs de mémoire semblables (20a, 20b, 20c), n étant un entier positif, réalisés sur une même puce de circuit, caractérisée en ce que chaque dispositif comporte des boucles mineures (22) servant au stockage des bulles (48), au moins une boucle majeure (24) servant de boucle d'accès aux boucles mineures (22), des premiers conducteurs électriques (26) permettant le transfert des bulles des boucles mineures vers la boucle majeure et réciproquement, les premiers conducteurs des 3n dispositifs, identiques et disposés selon une même direction, recevant simultanément une même impulsion de courant afin de transférer simultanément sur les différents dispositifs de mémoire (20a, 20b, 20c) des bulles magnétiques, des boucles mineures (22) vers la boucle majeure (24) correspondante et réciproquement, un second conducteur électrique (34a, 34b, 34c) permettant d'engendrer des bulles sur la boucle majeure, et un moyen électrique (38a, 38b, 38c) permettant de détecter les bulles sur la boucle majeure, ce moyen (38a, 38b, 38c) étant constitué par un troisième conducteur électrique (56a, 56b, 56c) d'extension-contraction des bulles et par un élément magnéto-résistif (58a, 58b, 58c), les seconds conducteurs (34a, 34b, 34c) des 3n dispositifs étant identiques, reliés électriquement en série et disposés suivant des premières directions faisant entre elles un angle de 120°, ces premières directions correspondant aux trois axes cristallographiques, coplanaires, de facile aimantation (112, 121, 211) de la couche de matériau magnétique monocristallin (50) dans laquelle sont réalisés les motifs de propagation (46) non implantés, les moyens électriques (38a, 38b, 38c) des 3n dispositifs étant identiques, reliés électriquement en série et disposés suivant des secondes directions faisant entre elles un angle de 120°, les bulles (48) des 3n dispositifs étant soumises à l'action d'un unique champ tournant permettant la propagation des bulles (48) le long des motifs non implantés.

2. Mémoire à bulles magnétiques comportant des motifs contigus de propagation des bulles et reliés électriquement entre eux, 6n dispositifs de mémoire semblables (20a, 20b, 20c) n étant un entier positif, réalisés sur une même puce de circuit, caractérisée en ce que chaque dispositif comporte des boucles mineures (22) servant au stockage des bulles (48), au moins une boucle majeure (24) servant de boucle d'accès aux boucles mineures (22), des premiers conducteurs électriques (26) permettant le transfert des bulles des boucles mineures vers la boucle majeure et réciproquement, les premiers conducteurs des 6n dispositifs, identiques et disposés selon une même direction, recevant simultanément une même impulsion de courant afin de transférer simultanément sur les différents dispositifs de mémoire (20a, 20b, 20c) des bulles magnétiques, des boucles mineures (22) vers la boucle majeure (24) correspondante et réciproquement, un second conducteur électrique (34a, 34b, 34c) permettant d'engendrer des bulles sur la boucle majeure et un moyen électrique (38a, 38b, 38c) permettant de détecter les bulles sur la boucle majeure, ce moyen (38a, 38b, 38c) étant constitué par un troisième conducteur électrique (56a, 56b, 56c) d'extension-contraction des bulles et par un élément magnéto-résistif (58a, 58b, 58c), les seconds conducteurs (34a, 34b, 34c) des 6n dispositifs étant identiques, reliés électriquement entre eux en série, regroupés en groupes de trois et orientés de façon que les seconds conducteurs d'un même groupe soient disposés selon des premières directions faisant un angle de 120°, ces premières directions correspondant aux trois axes cristallographiques coplanaires, de facile aimantation (112, 121, 211) de la couche de matériau magnétique monocristallin (50) dans laquelle sont réalisés les motifs de propagation (46) non implantés, les moyens électriques (38a, 38b, 38c) des 6n dispositifs étant identiques, reliés électriquement entre eux en série et disposés suivant des secondes directions faisant entre elles un angle de 60°, les bulles (48) des 6n dispositifs étant soumises à l'action d'un unique champ tournant permettant la propagation des bulles (48) le long des motifs non implantés.

3. Mémoire à bulles selon la revendication 1 ou 2, caractérisée en ce que les bulles (48) qui se propagent sur les boucles majeures (24) sont espacées de un, deux ou quatre pas les unes des autres.

4. Mémoire à bulles selon la revendication 1 ou 2, caractérisée en ce que chaque dispositif de mémoire (20a, 20b, 20c) comprend en outre, un quatrième conducteur électrique (30) permettant de dupliquer les bulles magnétiques, ces quatrièmes conducteurs étant identiques et disposés selon une même direction.

5. Mémoire à bulles selon la revendication 1 ou 2, caractérisée en ce que les troisièmes conducteurs électriques d'extension-contraction (56a, 56b, 56c) des bulles des moyens électriques (38a, 38b, 38c) sont respectivement reliés électriquement entre eux et en série.

6. Mémoire à bulles selon la revendication 1 ou 2, caractérisée en ce que les éléments magnéto-résistifs (58a, 58b, 58c) des moyens électriques (38a, 38b, 38c) sont respectivement reliés électriquement entre eux et en série.

7. Mémoire à bulles selon la revendication 1, caractérisée en ce que les dispositifs de mémoire (20a, 20b, 20c) sont au nombre de trois.

8. Mémoire à bulles selon la revendication 2, caractérisée en ce que les dispositifs de mémoire (20a, 20b, 20c) sont au nombre de six.

9. Mémoire à bulles selon la revendication 8, caractérisée en ce que les moyens électriques sont regroupés en deux groupes de trois, et disposés de façon que les six moyens électriques fassent entre eux un angle de 60°, les moyens électriques d'un même groupe faisant entre eux un angle de 120°.

10. Procédé permettant de commander les quatrièmes conducteurs électriques d'une mémoire à bulles selon la revendication 4, caractérisé en ce que l'on applique simultanément sur tous les quatrièmes conducteurs (30) une même impulsion de courant afin de dupliquer des bulles magnétiques simultanément sur les différents dispositifs de mémoire (20a, 20b, 20c).

11. Procédé permettant de commander les seconds conducteurs d'une mémoire à bulles selon la revendication 1, caractérisé en ce que l'on applique successivement sur les seconds conducteurs (34a, 34b, 34c) une impulsion de courant (52a, 52b, 52c), les trois impulsions de courant étant espacées les unes des autres d'un temps égal à q/3 période de rotation du champ magnétique tournant, permettant la propagation des bulles (48) le long des motifs non implantés (46), q étant le nombre de pas séparant les bulles les unes des autres sur les boucles majeures (24).

12. Procédé selon la revendication 11, caractérisé en ce que les trois impulsions de courant (52a, 52b, 52c) présentent la même polarité.

13. Procédé permettant de commander les seconds conducteurs d'une mémoire à bulles selon la revendication 2, caractérisé en ce que l'on applique successivement sur les seconds conducteurs une impulsion de courant (54a, 54b, 54c, 54d, 54e, 54f), les six impulsions de courant étant espacées les unes des autres d'un temps égal à q/6 période de rotation du champ magnétique tournant, permettant la propagation des bulles le long des motifs non implantés (46), q étant le nombre de pas séparant les bulles les unes des autres sur les boucles majeures (24).

14. Procédé selon la revendication 13, caractérisé en ce que l'on commande en alternance les deux groupes de seconds conducteurs, les impulsions de courant associées à l'un desdits groupes (54a, 54b, 54c) étant de polarité inverse à celles associées à l'autre groupe (54d, 54e, 54f).

15. Procédé selon la revendication 11, caractérisé en ce que, à chaque second conducteur étant associés des motifs de propagation (46) présentant deux sommets (49), on engendre les bulles à partir desdits sommets.

16. Procédé permettant de commander les moyens électriques d'une mémoire à bulles selon la revendication 7, caractérisé en ce que la détection des bulles (48) par lesdits moyens (38a, 38b, 38c) comportant une phase d'allongement des bulles et une phase de contraction desdites bulles, on commande successivement lesdits moyens (38a, 38b, 38c) en appliquant sur le conducteur électrique d'extension-contraction (56a, 56b, 56c) constituant chaque moyen deux impulsions de courant de polarité inverse, l'une (62a, 62b, 62c) servant à l'allongement et l'autre (64a, 64b, 64c) à la contraction des bulles (48), les impulsions de courant servant audit allongement et les impulsions de courant servant à ladite contraction étant, respectivement, espacées les unes des autres d'un temps égal à q/3 période de rotation du champ magnétique tournant, permettant la propagation des bulles le long des motifs non implantés (46), q étant le nombre de pas séparant les bulles les unes des autres sur les boucles majeures (24).

17. Procédé permettant de commander les moyens électriques d'une mémoire à bulles selon la revendication 9, caractérisé en ce que, la détection des bulles (48) par lesdits moyens comportant une phase d'allongement des bulles et une phase de contraction desdites bulles, on commande successivement lesdits moyens de chaque groupe en appliquant sur le conducteur électrique d'extension-contraction constituant chaque moyen deux impulsions de courant de polarité inverse, l'une (66a, 66b, 66c ou 68a, 68b, 68c) servant à l'allongement et l'autre (68a, 68b, 68c ou 66a, 66b, 66c) à la contraction des bulles, toutes les impulsions de courant appliquées sur chaque groupe étant espacées les unes des autres d'un temps égal à q/6 période de rotation du champ magnétique tournant, permettant la propagation des bulles (46) le long des motifs non implantés (46), q étant le nombre de pas séparant les bulles les unes des autres sur les boucles majeures, la commande des deux groupes desdits moyens étant réalisée simultanément, chaque impulsion servant à l'allongement des bulles au niveau d'un des moyens d'un groupe et à la contraction d'autres bulles au niveau d'un des moyens de l'autre groupe.

18. Procédé selon la revendication 17, caractérisé en ce que les impulsions présentent toutes la même amplitude et la même durée.

19. Procédé selon la revendication 16 ou 17, caractérisé en ce que à chaque moyen électrique étant associés des motifs de propagation (46) réalisés dans la couche de matériau magnétique monocristallin (50), présentant trois axes cristallographiques coplanaires, de facile aimantation (112, 121, 211), formant entre eux un angle de 120°, ces motifs, présentant une forme telle que deux cavités (47) sont délimitées entre deux motifs adjacents, et étant alignées suivant un axe (43) parallèle à l'un des axes cristallographiques de ladite couche (50), on allonge les bulles à partir de l'une desdites cavités.

20. Procédé selon la revendication 16 ou 17, caractérisé en ce que, à chaque moyen électrique étant associés des motifs de propagation (46) présentant deux sommets (49), on allonge les bulles à partir de l'un desdits sommets.

## Claims

1. Magnetic bubble memory including contiguous patterns for the propagation of the bubbles and, electrically connected to each other, 3n similar memory devices (20a, 20b, 20c), n being a positive integer, produced on a same circuit chip, characterized in that each device includes minor loops (22) used for the storage of bubbles (48), at least one major loop (24) used as an access loop to the minor loops (22), first electrical conductors (26) enabling the transfer of the bubbles from the minor loops to the major loop and vice-versa, the first conductors of the 3n devices, identical and arranged in a same direction, simultaneously receiving a same current pulse in order to simultaneously transfer, in the various memory devices (20a, 20b, 20c), magnetic bubbles from the minor loops (22) to the corresponding major loop (24) and vice-versa, a second electrical conductor (34a, 34b, 34c) enabling the generation of bubbles in the major loop, and an electrical means (38a, 38b, 38c) enabling the detection of the bubbles in the major loop, this means (38a, 38b, 38c) being constituted by a third electrical conductor (56a, 56b, 56c) for the extension/contraction of the bubbles and by a magneto-resistive element (58a, 58b, 58c), the second conductors (34a, 34b, 34c) of the 3n devices being identical, electrically connected in series and arranged in first directions making between them an angle of 120°, these first directions corresponding to the three coplanar, crystallographic axes of easy magnetization (112, 121, 211) of the layer of monocrystalline magnetic material (50) in which the non-implanted propagation patterns (46) are produced, the electrical means (38a, 38b, 38c) of the 3n devices being identical, electrically connected in series and arranged along second directions making between them an angle of 120°, the bubbles (48) of the 3n devices being subjected to the action of a single rotating field enabling the propagation of the bubbles (48) along the non-implanted patterns.

2. Magnetic bubble memory including contiguous bubble propagation patterns and, electrically connected to each other, 6n similar memory devices (20a, 20b, 20c), n being a positive integer, produced on a same circuit chip, characterized in that each device includes minor loops (22) used for the storage of bubbles (48), at least one major loop (24) used as an access loop to the minor loops (22), first electrical conductors (26) enabling the transfer of the bubbles from the minor loops to the major loop and vice-versa, the first conductors of the 6n devices, identical and arranged along a same direction, simultaneously receiving a same current pulse in order to simultaneously transfer, in the various memory devices (20a, 20b, 20c), magnetic bubbles from the minor loops (22) to the corresponding major loop (24) and vice-versa, a second electrical conductor (34a, 34b, 34c) enabling the generation of bubbles in the major loop and an electrical means (38a, 38b, 38c) enabling the detection of the bubbles in the major loop, this means (38a, 38b, 38c) being constituted by a third electrical conductor (56a, 56b, 56c) for the extension/contraction of the bubbles and by a magneto-resistive element (58a, 58b, 58c), the second conductors (34a, 34b, 34c) of the 6n devices being identical, electrically connected to each other in series, grouped in groups of three and oriented in such a way that the second conductors of a same group are arranged along first directions making an angle of 120°, these first directions corresponding with the three coplanar crystallographic axes of easy magnetization (112, 121, 211) of the layer of monocrystalline magnetic material (50) in which non-implanted propagation patterns (46) are produced, the electrical means (38a, 38b, 38c) of the 6n devices being identical, electrically connected to each other in series and arranged along second directions making between them an angle of 60°, the bubbles (48) of the 6n devices being subjected to the action of a single rotating field enabling the propagation of the bubbles (48) along the non-implanted patterns.

3. Bubble memory according to Claim 1 or 2, characterized in that the bubbles (48) which propagate in the major loops (24) are spaced by one, two or four steps from each other.

4. Bubble memory according to Claim 1 or 2, characterized in that each memory device (20a, 20b, 20c) also includes a fourth electrical conductor (30) enabling the duplication of the magnetic bubbles, these fourth conductors being identical and arranged in a same direction.

5. Bubble memory according to Claim 1 or 2, characterized in that the third electrical conductors (56a, 56b, 56c) for the extension/contraction of the bubbles of the electrical means (38a, 38b, 38c) are electrically connected to each other and in series respectively.

6. Bubble memory according to Claim 1 or 2, characterized in that the magneto-resistive elements (58a, 58b, 58c) of the electrical means (38a, 38b, 38c) are electrically connected to each other and in series respectively.

7. Bubble memory according to Claim 1, characterized in that the memory devices (20a, 20b, 20c) are three in number.

8. Bubble memory according to Claim 2, characterized in that the memory devices (20a, 20b, 20c) are six in number.

9. Bubble memory according to Claim 8, characterized in that the electrical means are grouped in two groups of three and arranged in such a way that the six electrical means make between them an angle of 60°, the electrical means of a same group making between them an angle of 120°.

10. Process enabling the control of the fourth electrical conductors of a bubble memory according to Claim 4, characterized in that there is simultaneously applied on all of the fourth conductors (30) a same current pulse in order to duplicate the magnetic bubbles simultaneously in the various memory devices (20a, 20b, 20c).

11. Process enabling the control of the second conductors of a bubble memory according to Claim 1, characterized in that there is successively applied on the second conductors (34a, 34b, 34c) a current pulse (52a, 52b, 52c), the three current pulses being spaced from each other by a time equal to q/3 of a period of rotation of the rotating magnetic field, enabling the propagation of the bubbles (48) along the non-implanted patterns (46), q being the number of steps separating the bubbles from each other in the major loops (24).

12. Process according to Claim 11, characterized in that the three current pulses (52a, 52b, 52c) have the same polarity.

13. Process enabling the control of the second conductors of a bubble memory according to Claim 2, characterized in that there is applied successively on the second conductors a current pulse (54a, 54b, 54c, 54d, 54e, 54f), the six current pulses being spaced from each other by a time equal to q/6 of a period of rotation of the rotating magnetic field, enabling the propagation of the bubbles along the non-implanted patterns (46), q being the number of steps separating the bubbles from each other in the major loops (24).

14. Process according to Claim 13, characterized in that the two groups of second conductors are controlled alternately, the current pulses associated with one of the said groups (54a, 54b, 54c) being of reverse polarity with respect to those associated with the other group (54d, 54e, 54f).

15. Process according to Claim 11, characterized in that, at each second conductor being associated with propagation patterns (46) having two peaks (49), the bubbles are generated starting from the said peaks.

16. Process enabling the control of the electrical means of a bubble memory according to Claim 7, characterized in that, the detection of the bubbles (48) by the said means (38a, 38b, 38c) including a phase of elongation of the bubbles and a phase of contraction of the said bubbles, the said means (38a, 38b, 38c) are successively controlled by applying on the extension/contraction electrical conductor (56a, 56b, 56c), constituting each means, two current pulses of reverse polarity, one (62a, 62b, 62c) being used for the elongation and the other (64a, 64b, 64c) for the contraction of the bubbles (48), the current pulses used for the said elongation and the current pulses used for the said contraction being respectively spaced from each other by a time equal to q/3 of a period of rotation of the rotating magnetic field, enabling the propagation of the bubbles along the non-implanted patterns (46), q being the number of steps separating the bubbles from each other in the major loops (24).

17. Process enabling the control of the electrical means of a bubble memory according to Claim 9, characterized in that, for the detection of the bubbles (48) by the said means, including a phase of elongation of the bubbles and a phase of contraction of the said bubbles, the said means of each group are successively controlled by applying on the electrical extension/contraction conductor constituting each means two current pulses of reverse polarity, one (66a, 66b, 66c or 68a, 68b, 68c) being used for the elongation and the other (68a, 68b, 68c or 66a, 66b, 66c) for the contraction of the bubbles, all of the current pulses applied on each group being spaced from each other by a time equal to q/6 of a period of rotation of the rotating magnetic field, enabling the propagation of the bubbles (48) along the non-implanted patterns (46), q being the number of steps separating the bubbles from each other in the major loops, the control of the two groups of the said means being carried out simultaneously, each pulse being used for the elongation of the bubbles at one of the means of a group and for the contraction of other bubbles at one of the means of the other group.

18. Process according to Claim 17, characterized in that the pulses all have the same amplitude and the same duration.

19. Process according to Claim 16 or 17, characterized in that, at each electrical means being associated with propagation patterns (46) produced in the monocrystalline magnetic material layer (50), having three coplanar crystallographic axes of easy magnetization (112, 121, 211), forming between them an angle of 120°, these patterns having a shape such that two cavities (47) are outlined between two adjacent patterns, and being aligned along an axis (43) parallel to one of the crystallographic axes of the said layer (50), the bubbles are elongated starting from one of the said cavities.

20. Process according to Claim 16 or 17, characterized in that, at each electrical means being associated with propagation patterns (46) having two peaks (49), the bubbles are elongated starting from one of the said peaks.

## Patentansprüche

1. Magnetischer Blasenspeicher, enthaltend aneinanderstoßende Blasenausbreitungsmuster, die elektrisch miteinander verbunden sind, 3n einander ähnliche Speichereinrichtungen (20a, 20b, 20c), wobei n eine positive ganze Zahl ist, die auf demselben Schaltkreissubstrat realisiert sind, dadurch gekennzeichnet, daß jede Einrichtung enthält : Unterschleifen (22), die der Speicherung der Blasen (48) dienen, wobei wenigstens eine Hauptschleife (24) als Zugriffsschleife für die Unterschleifen (22) dient, erste elektrische Leiter (26), die die Übertragung der Blasen aus den Unterschleifen in die Hauptschleife und umgekehrt ermöglichen, wobei die ersten Leiter der 3n Einrichtungen, identisch und in gleicher Richtung angeordnet, gleichzeitig einen gleichen Stromimpuls empfangen, um gleichzeitig an den verschiedenen Speichereinrichtungen (20a, 20b, 20c) magnetische Blasen von den Unterschleifen (22) gegen die zugehörige Hauptschleife (24) und umgekehrt zu übertragen, einen zweiten elektrischen Leiter (34a, 34b, 34c), der die Erzeugung von Blasen an der Hauptschleife erlaubt, und eine elektrische Einrichtung (38a, 38b, 38c), die die Ermittlung von Blasen an der Hauptschleife ermöglicht, wobei diese Einrichtung (38a, 38b, 38c) von einem dritten elektrischen Leiter (56a, 56b, 56c) zur Ausdehnung und Zusammenziehung der Blasen und durch ein magneto-resistives Element (58a, 58b, 58c) gebildet ist, die zweiten Leiter (34a, 34b, 34c) der 3n Einrichtungen, die identisch sind, elektrisch in Serie geschaltet und den ersten Richtungen folgend angeordnet sind, zwischen sich einen Winkel von 120° bildend, wobei die ersten Richtungen den drei kristallographischen, koplanaren Achsen zur einfachen Magnetisierung (112, 121, 211) des Mantels aus monokristallinem magnetischen Material (50), in denen die nicht implantierten Ausbreitungsmuster (46) realisiert sind, entsprechen, die elektrischen Einrichtungen (38a, 38b, 38c) der 3n Einrichtungen, die identisch sind, elektrisch in Serie geschaltet und den zweiten Richtungen folgend angeordnet sind, zwischen sich einen Winkel von 120° bildend, die Blasen (48) der 3n Einrichtungen der Wirkung eines einzigen Drehfeldes unterworfen sind, das die Ausbreitung der Blasen (48) längs der nicht implantierten Muster erlaubt.

2. Magnetischer Blasenspeicher mit aneinanderstoßenden Blasenausbreitungsmustern, die elektrisch miteinander verbunden sind, 6n einander ähnliche Speichereinrichtungen (20a, 20b, 20c), wobei n eine positive ganze Zahl ist, die auf demselben Schaltungssubstrat realisiert sind, dadurch gekennzeichnet, daß jede Einrichtung enthält : Unterschleifen (22), die der Speicherung der Blasen (48) dienen, wenigstens eine Hauptschleife (24), die als Zugriffsschleife zu den Unterschleifen (22) dient, erste elektrische Leiter (26), die die Übertragung der Blasen von den Unterschleifen gegen die Hauptschleife und umgekehrt gestatten, wobei die übereinstimmenden ersten Leiter der 6n Einrichtungen, die in einer gleichen Richtung angeordnet sind, gleichzeitig einen gleichen Stromimpuls empfangen, um gleichzeitig an den unterschiedlichen Speichereinrichtungen (20a, 20b, 20c) magnetische Blasen von den Unterschleifen (22) gegen die entsprechende Hauptschleife (24) und umgekehrt zu übertragen, einen zweiten elektrischen Leiter (34a, 34b, 34c), der die Erzeugung von Blasen an der Hauptschleife ermöglicht, und eine elektrische Einrichtung (38a, 38b, 38c), die die Ermittlung der Blasen an der Hauptschleife ermöglicht, wobei diese Einrichtung (38a, 38b, 38c) von einem dritten elektrischen Leiter (56a, 56b, 56c) zur Ausdehnung und Zusammenziehung der Blasen und von einem magneto-resistiven Element (58a, 58b, 58c) gebildet ist, die übereinstimmenden zweiten Leiter (34a, 34b, 34c) der 6n Einrichtungen, die untereinander in Serie geschaltet sind, in Dreiergruppen umgeschichtet und so angeordnet sind, daß die zweiten Leiter einer gleichen Gruppe in ersten Richtungen angeordnet sind, die einen Winkel von 120° einschließen, wobei diese ersten Richtungen den drei kristallographischen koplanaren Achsen zur leichten Magnetisierung (112, 121, 211) des Mantels aus monokristallinem magnetischen Material (50), in welchem die nicht implantierten Ausbreitungsmuster (46) realisiert sind, entsprechen, die übereinstimmenden elektrischen Einrichtungen (38a, 38b, 38c) der 6n Einrichtungen, die elektrisch miteinander in Serie geschaltet und in den zweiten Richtungen angeordnet sind, untereinander einen Winkel von 60° bilden, die Blasen (48) der 6n Einrichtungen der Wirkung eines einzigen Drehfeldes unterworfen sind, das die Ausbreitung der Blasen (48) längs der nicht implantierten Muster gestattet.

3. Blasenspeicher nach Anspruch 1 oder 2, dadurch gekennzeichnet, daß die Blasen (48), die sich auf die Hauptschleifen (24) ausbreiten, voneinander in einem, zwei oder vier Schritten beabstandet sind.

4. Blasenspeicher nach Anspruch 1 oder 2, dadurch gekennzeichnet, daß jede Speichereinrichtung (20a, 20b, 20c) weiterhin einen vierten elektrischen Leiter (30) enthält, der die Verdopplung der magnetischen Blasen gestattet, wobei die übereinstimmenden vierten Leiter in einer gleichen Richtung angeordnet sind.

5. Blasenspeicher nach Anspruch 1 oder 2, dadurch gekennzeichnet, daß die dritten elektrischen Leiter (56a, 56b, 56c) zur Ausdehnung und Zusammenziehung der Blasen der elektrischen Einrichtungen (38a, 38b, 38c) jeweils elektrisch untereinander verbunden und in Serie geschaltet sind.

6. Blasenspeicher nach Anspruch 1 oder 2, dadurch gekennzeichnet, daß die magneto-resistiven Elemente (58a, 58b, 58c) der elektrischen Einrichtungen (38a, 38b, 38c) jeweils elektrisch untereinander verbunden und in Serie geschaltet sind.

7. Blasenspeicher nach Anspruch 1, dadurch gekennzeichnet, daß die Speichereinrichtungen (20a, 20b, 20c) der Anzahl nach drei sind.

8. Blasenspeicher nach Anspruch 2, dadurch gekennzeichnet, daß die Speichereinrichtungen (20a, 20b, 20c) der Anzahl nach sechs sind.

9. Blasenspeicher nach Anspruch 8, dadurch gekennzeichnet, daß die elektrischen Einrichtungen in zwei Dreiergruppen umgeschichtet sind und derart angeordnet sind, daß die sechs elektrischen Einrichtungen untereinander einen Winkel von 60° bilden, wobei die elektrischen Einrichtungen einer gleichen Gruppe untereinander einen Winkel von 120° bilden.

10. Verfahren zur Steuerung der vierten elektrischen Leiter eines Blasenspeichers nach Anspruch 4, dadurch gekennzeichnet, daß man gleichzeitig an alle vierten Leiter (30) einen gleichen Stromimpuls anlegt, um die magnetischen Blasen gleichzeitig an den verschiedenen Speichereinrichtungen (20a, 20b, 20c) zu verdoppeln.

11. Verfahren zur Steuerung der zweiten Leiter eines Blasenspeichers nach Anspruch 1, dadurch gekennzeichnet, daß man an die zweiten Leiter (34a, 34b, 34c) nacheinander einen Stromimpuls (52a, 52b, 52c) anlegt, wobei die drei Stromimpulse voneinander einen zeitlichen Abstand von q/3 der Drehperiode des magnetischen Drehfeldes haben, was die Ausbreitung der Blasen (48) längs der nicht implantierten Muster (46) erlaubt, wobei q die Anzahl der Schritte ist, die die Blasen voneinander an den Hauptschleifen (24) trennen.

12. Verfahren nach Anspruch 11, dadurch gekennzeichnet, daß die drei Stromimpulse (52a, 52b, 52c) die gleiche Polarität aufweisen.

13. Verfahren zur Steuerung der zweiten Leiter eines Blasenspeichers nach Anspruch 2, dadurch gekennzeichnet, daß man an die zweiten Leiter nacheinander einen Stromimpuls (54a, 54b, 54c, 54d, 54e, 54f) anlegt, wobei die sechs Stromimpulse voneinander einen zeitlichen Abstand von q/6 der Drehperiode des magnetischen Drehfeldes haben, was die Ausbreitung der Blasen längs der nicht implantierten Muster (46) erlaubt, wobei q die Anzahl der Schritte ist, die die Blasen an den Hauptschleifen (24) voneinander trennen.

14. Verfahren nach Anspruch 13, dadurch gekennzeichnet, daß man abwechselnd die zwei Gruppen der zweiten Leiter steuert, wobei die Stromimpulse, die einer der genannten Gruppen (54a, 54b, 54c) zugeordnet sind, entgegengesetzte Polarität zu jenen aufweisen, die der anderen Gruppe (54d, 54e, 54f) zugeordnet sind.

15. Verfahren nach Anspruch 11, dadurch gekennzeichnet, daß man an jedem zweiten Leiter, der Ausbreitungsmustern (46) zugeordnet ist, die zwei Spitzen (49) aufweisen, Blasen von den Spitzen an erzeugt.

16. Verfahren zur Steuerung der elektrischen Einrichtungen eines Blasenspeichers nach Anspruch 7, dadurch gekennzeichnet, daß die Ermittlung der Blasen (48) durch die genannten Einrichtungen (38a, 38b, 38c) eine Verlängerungsphase der Blasen und eine Kontraktionsphase der Blasen umfaßt, daß man nacheinander die Einrichtungen (38a, 38b, 38c) steuert, indem man an den elektrischen Leiter zur Ausdehnung/Zusammenziehung (56a, 56b, 56c), der jede Einrichtung bildet, zwei Stromimpulse umgekehrter Polarität anlegt, von denen einer (62a, 62b, 62c) der Verlängerung und der andere (64a, 64b, 64c) der Kontraktion der Blasen (48) dient, wobei die Stromimpulse, die der Verlängerung dienen, und die Stromimpulse, die der Kontraktion dienen, jeweils voneinander einen zeitlichen Abstand von q/3 der Drehperiode des magnetischen Drehfeldes haben, was die Ausbreitung der Blasen längs der nicht implantierten Muster (46) ermöglicht, wobei q die Zahl der Schritte ist, die die Blasen voneinander an den Hauptschleifen (24) trennen.

17. Verfahren zur Steuerung der elektrischen Einrichtungen eines Blasenspeichers nach Anspruch 9, dadurch gekennzeichnet, daß die Ermittlung der Blasen (45) durch die genannten Einrichtungen eine Blasenverlängerungsphase und eine Blasenkontraktionsphase umfaßt, daß man nacheinander die Einrichtungen jeder Gruppe steuert, indem man an den elektrischen Leiter zur Ausdehnung/Zusammenziehung, der jede Einrichtung bildet, zwei Stromimpulse umgekehrter Polarität anlegt, von denen der eine (66a, 66b, 66c oder 68a, 68b, 68c) der Verlängerung und der andere (68a, 68b, 68c oder 66a, 66b, 66c) der Kontraktion der Blasen dient, wobei alle Stromimpulse, die jeder Gruppe zugeführt werden, voneinander einen zeitlichen Abstand von q/6 der Drehperiode des magnetischen Drehfeldes haben, was die Ausdehnung der Blasen (48) längs der nicht implantierten Muster (46) erlaubt, wobei q gleich der Anzahl der Schritte ist, die die Blasen voneinander an den Hauptschleifen trennen, wobei die Steuerung der zwei Gruppen der genannten Einrichtungen gleichzeitig erfolgt, wobei jeder Impuls der Verlängerung der Blasen im Niveau einer der Einrichtungen einer Gruppe und der Kontraktion der anderen Blasen im Niveau der Einrichtungen der anderen Gruppe dient.

18. Verfahren nach Anspruch 17, dadurch gekennzeichnet, daß die Impulse sämtlich die gleiche Amplitude und die gleiche Dauer aufweisen.

19. Verfahren nach Anspruch 16 oder 17, dadurch gekennzeichnet, daß man an jeder elektrischen Einrichtung, die den Ausbreitungsmustern (46) zugeordnet ist, die in der Schicht aus monokristallinem magnetischen Material (50) realisiert sind, die drei kristallographische, koplanare Achsen für die einfache Magnetisierung (112, 121, 211) aufweisen, unter sich einen Winkel von 120° bildend, wobei die Muster, die eine Form wie zwei Hohlräume (47) bilden, zwischen zwei benachbarten Mustern begrenzt sind und in einer Achse (43) parallel zu einer der kristallographischen Achsen der genannten Schicht (50) angeordnet sind, die Blasen von den genannten Hohlräumen ausgehend verlängert.

20. Verfahren nach Anspruch 16 oder 17, dadurch gekennzeichnet, daß man bei jeder elektrischen Einrichtung, die den Ausbreitungsmustern (46), die zwei Spitzen (49) aufweisen, zugeordnet sind, die Blasen von den genannten Spitzen ausgehend verlängert.

FIG.1

FIG.2

FIG.3

FIG.4

FIG.5a

FIG.5b

FIG.8a

FIG.8b

FIG.6

FIG.7